# EUROPÄISCHE PATENTANMELDUNG

(11) **EP 1 983 489 A2**
(43) Veröffentlichungstag der Anmeldung: **22.10.2008**
(21) Anmeldenummer: 08001869.0
(22) Anmeldetag: 01.02.2008
(51) Int. Cl.: G07C 9/00

(54) **Elektrische Bedieneinheit, insbesondere Funkschlüssel für ein Kraftfahrzeug**

(30) Priorität: 18.04.2007 DE 102007018241
(71) Anmelder: Dr. Ing. h.c. F. Porsche Aktiengesellschaft, 70435 Stuttgart (DE)
(72) Erfinder: Bortolazzi, Jürgen, 72622 Nürtingen (DE); Sandvoss, Ralf, 70839 Gerlingen (DE); Serr, Helmut, 88677 Markdorf (DE); Deppner, Werner, 85055 Ingolstadt (DE); Donaubauer, Jürgen, 85055 Ingolstadt (DE); Reinwald, Martin, 88682 Salem-Weildorf (DE)

(57) **Zusammenfassung**

Die vorliegende Erfindung betrifft eine elektrische Bedieneinheit, insbesondere einen Funkschlüssel für ein Kraftfahrzeug, mit zumindest zwei Gruppen von zumindest je einer Taste.

Erfindungsgemäß werden der Bedieneinheit zumindest zwei Leiterplattensegmente angeordnet, wobei auf dem ersten Leiterplattensegment die erste Gruppe von Tasten und auf dem zweiten Leiterplattensegment die zweite Gruppe von Tasten angeordnet werden. Dabei sind die erste Gruppe von Tasten in eine Richtung ausgerichtet und die zweite Gruppe von Tasten in die zu der ersten Gruppe entgegen gesetzte Richtung ausgerichtet. Die beiden Leiterplattensegmente sind zueinander mittels eines biegbaren elektrischen Verbindungsmittels elektrisch verbunden.

Durch die erfindungsgemäße Ausführung der Leiterplatte und die erfindungsgemäß verteilte Anordnung der Tasten auf den Leiterplattensegmenten werden vor allem das Arretierungsproblem gelöst und die unterschiedlichen Betätigungstoleranzen für die Tasten vermieden.

## Beschreibung

Die vorliegende Erfindung betrifft eine elektrische Bedieneinheit, insbesondere einen Funkschlüssel für ein Kraftfahrzeug, nach den Obenbegriffen der unabhängigen Ansprüche.

Derartige Bedieneinheit weist ein Gehäuse und darin integrierte elektrische Schaltungseinheit auf, welche auf einer elektrischen Leiterplatte angeordnet ist.

Zudem weist die Bedieneinheit je nach Ausführung eine oder mehrere Funktionstasten auf, die vorzugsweise auf eine Oberfläche der Bedieneinheit angeordnet und zur Betätigung der darunter liegenden, auf der Leiterplatte angeordneten Mikroschalter vorgesehen sind. Die Gebrauchsmusterschrift DE 20 2005 004 992 offenbart eine derartige Bedieneinheit bzw. einen derartigen Funkschlüssel.

Zur Erhöhung der Funktionalität der Bedieneinheit werden die Bedieneinheiten mit immer mehr Tasten ausgestattet. Um dabei noch die Bedieneinheiten möglichst klein zu halten, werden die Tasten auf zwei in zueinander entgegen gesetzten Richtungen gerichteten Oberflächen der Bedieneinheit verteilt angeordnet. Entsprechend werden die Mikroschalter auf der Leiterplatte, die mittels dieser Tasten betätigt werden, auf beide Seiten der Leiterplatte in der Bedieneinheit angeordnet. Dies führt zu dem Problem, dass die Arretierung der Leiterplatte an den Gehäuse-Innenwändern der Bedieneinheit aufgrund der von beiden Seiten einwirkenden Betätigungskräfte beim Betätigen der Tasten nicht wie bei herkömmlichen Bedieneinheiten ausgeführt werden kann. Zudem addieren sich die Fertigungstoleranzen der Leiterplatte und der Mikroschalter auf der Leiterplatte zu einer Toleranz, welche zu einer schlechten Funktionalität der Mikroschalter wie z. B. Nichtreagieren auf Tasten-Betätigung führen kann.

Der vorliegenden Erfindung liegt die Aufgabe zugrunde, eine Bedieneinheit, insbesondere einen Funkschlüssel mit zwei Gruppen von auf zwei entgegen gesetzten Oberflächen angeordneten Tasten anzugeben, welche(r) trotz der beidseitigen Anordnung der Tasten keinen der oben genannten Nachteile aufweist.

Diese Aufgabe wird erfindungsgemäß gelöst durch eine zweiteilige Leiterplatte in der Bedieneinheit bzw. im Funkschlüssel. Erfindungsgemäß wird die Leiterplatte in zwei Segmenten geteilt. Die Mikroschalter für die beiden Gruppen von in zwei entgegen gesetzten Oberflächen verteilt angeordneten Tasten werden auf diesen beiden Leiterplattensegmenten verteilt angeordnet.

Das heißt, die Mikroschalter für die erste Gruppe von Tasten, die auf einer ersten Oberfläche der Bedieneinheit angeordnet sind, auf einem ersten Leiterplattesegment angeordnet. Entsprechend werden die Mikroschalter für die zweite Gruppe von Tasten, wobei diese zweite Gruppe von Tasten auf einer zweiten Oberfläche der Bedieneinheit angeordnet ist, auf dem zweiten Leiterplattensegment angeordnet. Dabei liegen diese ersten und zweiten Oberflächen in zwei zueinander entgegen gesetzten Seiten der Bedieneinheit. Die Mikroschalter auf dem gleichen Leiterplattesegment werden auf der gleichen Seite des jeweiligen Leiterplattensegments angeordnet.

Die Leiterplattensegmente sind jeweils entsprechend der Betätigungsrichtung der darauf angeordneten Tasten befestigt und zueinander mittels eines biegbaren Verbindungsmittels elektrisch verbunden. Dieses biegbare Verbindungsmittel kann elektrische Flachleiterbahnen aber auch eine Gruppe von zumindest einem Leiterplattensegment sein, welches mittels einer Abknickkante mit den anderen Leiterplattensegmenten mechanisch verbunden ist und bzgl. der Ebene der nächsten Leiterplattensegmente abknickbar ist. Zudem sind diese Leiterplattensegmente mit elektrischen Leiterbahnen zur Herstellung von elektrischen Verbindungen zwischen den beiden Leiterplattensegmenten mit Mikroschaltern versehen.

Durch die erfindungsgemäße Ausführung der Leiterplatte sind vor allem die Unterschiede bei den Toleranzen bei der Betätigung der Tasten vermieden. Durch die Teilung der Leiterplatte in zwei Segmenten kann die Leiterplatte einfacher im Funkschlüsselgehäuse integriert und an den Gehäuse-Innenwänden befestigt werden. Dies führt wiederum zu einer höheren Designfreiheit bei den Bedieneinheiten.

Zudem ist die erfindungsgemäße Ausführung der Leiterplatte besonders vorteilhaft für eine Bedieneinheit bzw. einen Funkschlüssel, wenn diese bzw. dieser aufgrund eines geforderten Designs abgewinkelt gestaltet wird, sodass eine durchgängige, nicht geteilte Leiterplatte nicht in das Gehäuse der Bedieneinheit bzw. des Funkschlüssels untergebracht werden kann.

Im Folgenden wird die Erfindung anhand der Ausführungsbeispiele unter Zuhilfenahme von Figuren näher erläutet. Als Ausführungsbeispiel wird eine Leiterplatte für einen Funkschlüssel mit mehreren beidseitig angeordneten Mikroschaltern dargestellt. Dabei stellt die Figur 1 eine Leiterplatte für einen Funkschlüssel nach dem Stand der Technik dar. Die Figuren 2 und 3 zeigen je eine Leiterplatte für einen erfindungsgemäßen Funkschlüssel.

Es zeigen:

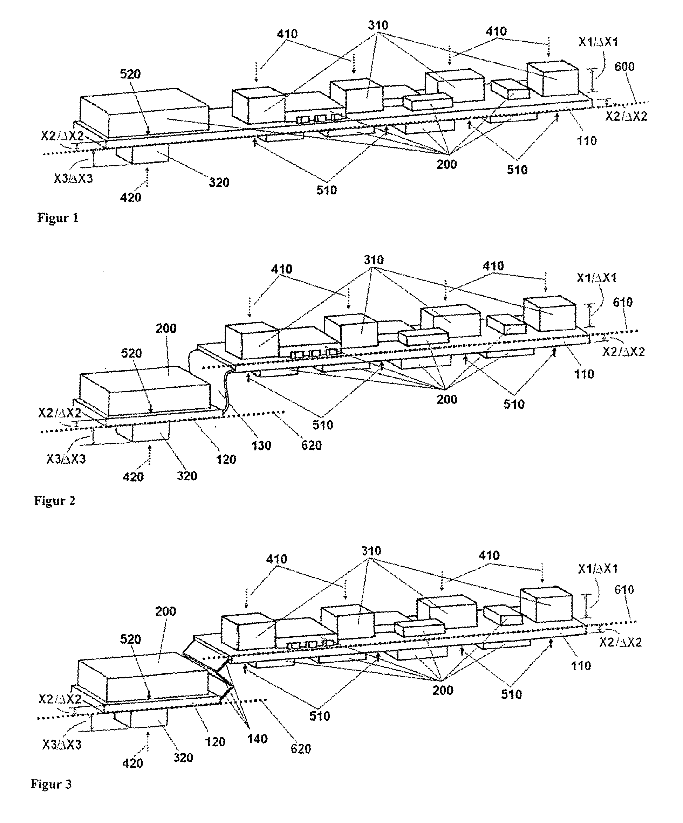

- Fig. 1:: eine Leiterplatte für eine einen Funkschlüssel nach dem Stand der Technik,
- Fig. 2:: ein Ausführungsbeispiel für eine Leiterplatte eines erfindungsgemäßen Funkschlüssels,
- Fig. 3:: ein weiteres Ausführungsbeispiel für eine Leiterplatte eines erfindungsgemäßen Funkschlüssels.

In der Figur 1 ist eine Leiterplatte für einen Funkschlüssel nach dem Stand der Technik gezeigt. Diese einstückige Leiterplatte 100 weist eine Gruppe von auf den beiden Seiten dieser Leiterplatte 100 angeordneten elektronischen Bauelementen 200 und zwei Gruppen von Mikroschaltern 310 und 320 auf, die ebenfalls auf den beiden Seiten der Leiterplatte 100 verteilt angeordnet sind. Die Leiterplatte 100 hat eine Dicke von X2. Die erste Gruppe von Mikroschaltern 310 auf einer Seite der Leiterplatte 100 weist eine vorzugsweise gleiche Bauhöhe von X1 auf. Entsprechend weist die zweite Gruppe von Mikroschaltern 320 auf eine andere Seite der Leiterplatte 100 eine vorzugsweise gleiche Bauhöhe von X3 auf. Die Fertigungstoleranzen für die Dicke X2 der Leiterplatte 100 und der Höhen X1 bzw. X3 der Mikroschalter 310, 320 betragen jeweils ΔX2, ΔX1, ΔX3. Da die Mikroschalter 310, 320 auf den beiden Seiten der Leiterplatte 100 verteilt angeordnet sind, addieren sich die Toleranzen ΔX1, ΔX2, ΔX3. Abhängig von der Befestigung der Leiterplatte 100, wirken sich diese Fertigungstoleranzen ΔX1, ΔX2, ΔX3 auf die Betätigungswege der Mikroschalter 310, 320 und führen beim Drücken der Tasten zu einem nicht einheitlichen taktilen Schaltverhalten der Mikroschalter 310, 320. Zudem ist eine einseitige Arretierung der Leiterplatte an den Gehäuse-Innenwänden aufgrund der von beiden Seiten einwirkenden Betätigungskräfte an den Tasten bzw. Mikroschaltern nicht ausreichend. Dies wird in der Figur 1 verdeutlicht.

Beispielsweise wird diese Leiterplatte 100, wie in der Figur 1 gezeigt ist, entlang der Befestigungslinie 600 an den Innenwänden des Gehäuses eines Funkschlüssels befestigt. Die Fertigungstoleranzen ΔX1, ΔX2, ΔX3 auf beiden Seiten der Befestigungslinie 600 addieren sich zu den Toleranzen bei den Betätigungswegen der Tasten. Diese Toleranz bei den Betätigungswegen wird im Folgenden Betätigungstoleranz genannt. Die Betätigungstoleranz für die erste Gruppe von Mikroschaltern 310 liegt bei ΔX1 + ΔX2. Dagegen liegt die Betätigungstoleranz für die zweite Gruppe von Mikroschaltern 320 bei ΔX3. So haben die beiden Gruppen von Mikroschaltern 310, 320 auf beiden Seiten der Leiterplatte 100 bzw. der Befestigungslinie 600 unterschiedliche Betätigungstoleranzen, welche zu den unterschiedlichen Betätigungswegen beim Betätigen der Tasten auf den beiden Oberflächen des Funkschlüssels führen.

Um die Druckkrafteinwirkung beim Betätigen der ersten Gruppe von Mikroschaltern 310 in die Betätigungsrichtung 410 entgegenzuwirken und somit eine Verbiegung der Leiterplatte 100 in die Richtung der Druckkrafteinwirkung zu vermeiden, wird die Leiterplatte 100 in die Pfeilrichtung 510 entlang der Befestigungslinie 600 arretiert. Da aber eine zweite Gruppe von Mikroschaltern 320 in die zu der ersten Gruppe von Mikroschaltern 310 entgegen gesetzte Richtung 420 betätigt werden muss, muss die Leiterplatte auch in die Pfeilrichtung 520 arretiert werden. Diese beidseitige Arretierung 510, 520 der Leiterplatte 100 führt zu einem technischen Mehraufwand und damit gebundenen Mehrkosten.

In den Figuren 2 und 3 ist je eine Leiterplatte für einen erfindungsgemäßen Funkschlüssel dargestellt. Demnach besteht diese Leiterplatte aus einer Gruppe von zumindest zwei Leiterplattensegmenten. Auf dem ersten Leiterplattensegment 110 ist die erste Gruppe von Mikroschaltern 310 angeordnet. Entsprechend ist auf dem zweiten Leiterplattesegment 120 die zweite Gruppe von Mikroschaltern 320 angeordnet. Dabei sind die Mikroschalter 310 der ersten Gruppe auf einer Seite des ersten Leiterplattensegments 110 angeordnet. Die zweite Gruppe von Mikroschaltern 320 sind auf der der ersten Gruppe von Mikroschaltern 310 entgegen gesetzten Seite des zweiten Leiterplattensegments 120 angeordnet. Die beiden Leiterplattensegmente 110 und 120 sind mittels biegbarer Flachleiterbahnen (oder flexibler Leiterplatte) 130, wie in der Figur 2 gezeigt ist, oder eine Gruppe von zumindest einem Leiterplattensegment 140, wie in der Figur 3 gezeigt ist, elektrisch verbunden.

Dabei sind die Leiterplattensegmente 140 mittels Abknickkanten zueinander bzw. mit den Leiterplattensegmenten 110, 120 mechanisch verbunden und entlang dieser Anknickkante zueinander bzw. bzgl. der Ebene des mit Mikroschaltern 310, 320 bestückten Leiterplattensegments 110, 120 abknickbar. Zudem sind diese Leiterplattensegmente 140 mit elektrischen Leiterbahnen zur Herstellung von elektrischen Verbindungen zwischen den beiden Leiterplattensegmenten 110, 120 mit Mikroschaltern 310, 320 versehen.

Durch die getrennte Arretierung des Leiterplattensegments 110 entlang der Befestigungslinie 610 bzw. des Leiterplattensegments 120 entlang der Befestigungslinie 620 weisen die Mikroschalter 310 und 320 jeweils eine Fertigungstoleranz von ΔX1 bzw. ΔX3. Bei einer gleichen Bauart der Mikroschalter 310 und der Mikroschalter 320 werden die beiden Fertigungstoleranzen gleich groß sein: ΔX1 = ΔX3. Dementsprechend weisen die Tasten, die auf den Oberflächen eines erfindungsgemäßen Funkschlüssels angeordnet sind, kleinere Betätigungstoleranzen auf als die Tasten eines Funkschlüssels nach dem Stand der Technik.

Durch die zweiteilige Ausführung der Leiterplatte und geteilte Befestigung der Leiterplattensegmente 110, 120 an den Innenwänden des Gehäuses entlang zwei Befestigungslinien 610, 620 sind die Unterschiede bei den Betätigungstoleranzen für die Mikroschalter 310, 320 auf den beiden Seiten der Leiterplatte um ΔX2 verringert. Zudem durch die getrennte Arretierung 510, 520 der beiden Leiterplattensegmente 110, 120 ist das Arretierungsproblem bei der einteiligen Leiterplatte nach dem Stand der Technik gelöst.

### Bezugszeichenliste

- 100: eine einstückige Leiterplatte
- 110: ein erstes Leiterplattensegment
- 120: ein zweites Leiterplattensegment
- 130: biegbare elektrische Flachleiternbahnen
- 140: eine Gruppe von abknickbaren Leiterplattensegmenten
- 200: elektronische Bauelementen
- 310: eine erste Gruppe von Mikroschaltern
- 320: eine zweite Gruppe von Mikroschaltern
- 410: die Betätigungsrichtung für die erste Gruppe von Mikroschaltern
- 420: die Betätigungsrichtung für die zweite Gruppe von Mikroschaltern
- 510: die der Betätigungsrichtung für die erste Gruppe von Mikroschaltern entgegenwirkende Arretierung für die Leiterplatte bzw. das erste Leiterplattensegment
- 520: die der Betätigungsrichtung für die zweite Gruppe von Mikroschaltern entgegenwirkende Arretierung für die Leiterplatte bzw. das zweite Leiterplattensegment
- 600: die Befestigungslinie für die Leiterplatte
- 610: die Befestigungslinie für das erste Leiterplattensegment
- 620: die Befestigungslinie für das zweite Leiterplattensegment

## Patentansprüche

1. Elektrische Bedieneinheit, insbesondere Funkschlüssel für ein Kraftfahrzeug, mit zumindest zwei Gruppen von zumindest je einer Taste, **dadurch gekennzeichnet, dass**
- diese Bedieneinheit zumindest zwei Leiterplattensegmente aufweist,
- wobei die erste Gruppe von zumindest einer Taste auf dem ersten Leiterplattensegment und die zweite Gruppe von zumindest einer Taste auf dem zweiten Leiterplattensegment angeordnet ist, und
- diese Leiterplattensegmente zueinander mittels eines biegbaren Verbindungsmittels elektrisch verbunden sind.

2. Bedieneinheit nach Anspruch 1, **dadurch gekennzeichnet, dass** die erste Gruppe von zumindest einer Taste in eine Richtung ausgerichtet und die zweite Gruppe von zumindest einer Taste in die zu der ersten Gruppe entgegen gesetzte Richtung ausgerichtet sind.

3. Bedieneinheit nach einem der vorangehenden Ansprüche, **dadurch gekennzeichnet, dass** die Leiterplattensegmente jeweils entsprechend der Betätigungsrichtung der darauf angeordneten Tasten befestigt sind.

4. Bedieneinheit nach einem der vorangehenden Ansprüche, **dadurch gekennzeichnet, dass** das biegbare Verbindungsmittel eine elektrische Flachleiterbahn ist.

5. Bedieneinheit nach einem der Ansprüche 1 bis 3, **dadurch gekennzeichnet, dass** das biegbare Verbindungsmittel eine Gruppe von zumindest einem abknickbaren Leiterplattensegment ist, wobei dieses abknickbare Leiterplattensegment mittels Abknickkanten, die zwischen diesem abknickbaren Leiterplattensegment und dem mit den Tasten bestückten Leiterplattensegment angeordnet sind und dieses abknickbare Leiterplattensegment bzgl. der Ebene des mit Tasten bestückten Leiterplattensegments abknickbar ist.
